# EUROPÄISCHE PATENTSCHRIFT

(11) **EP 1 110 439 B1**
(45) Veröffentlichungstag und Bekanntmachung des Hinweises auf die Patenterteilung: **02.02.2005**
(21) Anmeldenummer: 99953657.6
(22) Anmeldetag: 01.09.1999
(51) Int. Cl.: H05K 13/00

(54) **VERFAHREN UND VORRICHTUNG ZUM KALIBRIEREN EINES VERFAHRWEGS UND/ODER EINER WINKELLAGE EINER HALTEVORRICHTUNG IN EINER EINRICHTUNG ZUR HERSTELLUNG VON ELEKTRISCHEN BAUGRUPPEN SOWIE KALIBRIERSUBSTRAT**
METHOD AND DEVICE FOR CALIBRATING A DISPLACEMENT PATH AND/OR ANGULAR POSITION OF A HOLDING DEVICE IN A DEVICE FOR PRODUCING ELECTRICAL ASSEMBLY GROUPS AND CALIBRATION SUBSTRATE
PROCEDE ET DISPOSITIF POUR ETALONNER UN DEPLACEMENT ET/OU UNE POSITION ANGULAIRE D'UN SYSTEME DE RETENUE DANS UN DISPOSITIF DESTINE A PRODUIRE DES BLOCS DE COMPOSANTS ELECTRIQUES ET SUBSTRAT D'ETALONNAGE

(30) Priorität: 02.09.1998 DE 19839999
(43) Veröffentlichungstag der Anmeldung: 27.06.2001
(73) Patentinhaber: Siemens Aktiengesellschaft, 80333 München (DE)
(72) Erfinder: MÜLLER, Werner, D-82008 Unterhaching (DE)
(74) Vertreter: Berg, Peter, Dipl.-Ing.
(86) Internationale Anmeldenummer: PCT/DE1999/002744
(87) Internationale Veröffentlichungsnummer: WO 2000/015016

(56) Entgegenhaltungen:
- EP-A- 0 326 236
- US-A- 4 776 088
- US-A- 5 247 844

## Beschreibung

Die Erfindung bezieht sich auf ein Verfahren, eine Vorrichtung sowie ein Kalibriersubstrat zum Kalibrieren eines Verfahrwegs und/oder einer Winkellage einer Haltevorrichtung in einer Einrichtung zur Herstellung von elektrischen Baugruppen, insbesondere zum Bestücken von Leiterplatten mit Bauelementen, gemäß den Oberbegriffen der Patentansprüche 1, 6 oder 9.

Bisher wird zum Kalibrieren eines Verfahrwegs und/oder einer Winkellage einer Haltevorrichtung in einer Einrichtung zur Herstellung von elektrischen Baugruppen beispielsweise ein Kalibriersubstrat von der Art einer Leiterplatte an definierten Aufsetzstellen mit scheibenartigen Nachbildungen der Bauelemente bestückt. Die Nachbildungen werden dabei an der Haltevorrichtung von einem Magazin zum Kalibriersubstrat transportiert, analog zum Transport von Bauelementen aus Zuführeinheiten bis zur Aufsetzstelle auf einer Leiterplatte. Dabei ist es üblich, als Kalibriersubstrat eine leiterplattenähnliche Glasplatte zu verwenden, die in ihren Eckbereichen Zentriermarken aufweist. Die mit einer doppelseitigen Klebefolie oder mit einem Sprühkleber versehene Glasplatte wird in die zum Beispiel als Bestückautomat ausgebildete Einrichtung eingelegt, worauf die Lage der Zentriermarken mittels einer ortsauflösenden Leiterplattenkamera des Bestückautomaten ermittelt wird. Anschließend wird das Kalibriersubstrat an relativ zu den Zentriermarken definierten Stellen mit Nachbildungen von Bauelementen bestückt.

Die bestückte Glasplatte kann dann auf unterschiedliche Art und Weise vermessen werden. In einem ersten, beispielsweise aus US 5,537,204 oder aus DE 42 27 667 bekannten Verfahren wird die bestückte Glasplatte in eine optische Meßmaschine eingelegt. Die Glasplättchen weisen definierte Markierungen auf, deren Lage relativ zu den Zentriermarken der Glasplatte in der Meßmaschine ermittelt wird. Aus den Lageabweichungen von der angestrebten Ideallage werden in den Koordinatenrichtungen und hinsichtlich der Drehlage Korrekturwerte ermittelt, die als Korrekturparameter in den Bestückautomaten eingegeben werden, der diese Abweichungen beim späteren Bestükken von Leiterplatten mit Bauelementen berücksichtigt.

In der älteren deutschen Patentanmeldung 19711476.8 (veröffentlicht als WO 98/42171) wurde bereits ein weiteres Verfahren vorgeschlagen, wobei die bestückte Glasplatte im Bestückautomaten durch die Leiterplattenkamera vermessen wird. Die Leiterplattenkamera nimmt dafür in ihrem Gesichtsfeld lokale Referenzmarken, die auf der Glasplatte vorhanden sind, zusammen mit den definierten Markierungen der Glasplättchen auf, und ermittelt aus deren relativen Lage zueinander die entsprechenden Korrekturwerte, die anschließend beim Bestücken von Leiterplatten mit Bauelementen berücksichtigt werden.

Die Leiterplattenkameras weisen allerdings eine individuenabhängige und bei kurzbrennweitigen Objektiven besonders ausgeprägte Kameraverzerrung auf. Aus diesem Sachverhalt heraus entstehen bei der Vermessung von Bestückautomaten und der dabei mehrfachen Benutzung dieser optischen Sensoreinheit systematische Fehler im Bereich von ± 15 µm.

Es ist die Aufgabe der Erfindung, ein verbessertes Verfahren und eine Vorrichtung anzugeben, mit der der Verfahrweg und/oder die Winkellage einer Haltevorrichtung in einer Einrichtung zur Herstellung von elektrischen Baugruppen kalibriert werden kann, wobei eine in der Einrichtung vorhandene optische Sensoreinrichtung benutzt wird.

Die Aufgabe wird erfindungsgemäß gelöst durch ein Verfahren mit den kennzeichnenden Merkmalen des Patentanspruchs 1, durch eine Vorrichtung mit den kennzeichnenden Merkmalen des Patentanspruches 6 sowie durch ein Kalibriersubstrat mit den kennzeichnenden Merkmalen des Patentanspruchs 9.

Im erfindungsgemäßen Verfahren, mit der erfinderischen Vorrichtung sowie mit dem erfindungsgemäßen Kalibriersubstrat wird in vorteilhafter Weise durch den optischen Sensor zunächst der Abstand zwischen einer ersten und einer zweiten Korrekturmarke vermessen, die auf dem Kalibriersubstrat (der Glasplatte) in einem vorgegebenen Nennabstand aufgebracht sind. Durch den Vergleich des ermittelten Abstands mit dem Nennabstand wird ein Sensorkorrekturfaktor ermittelt, der bei der Lagebestimmung der einzelnen Nachbildungen auf dem Kalibriersubstrat berücksichtigt wird. Durch dieses Verfahren wird der optische Sensor in einem beschränkten Bereich seines Gesichtsfelds genau kalibriert (partielles mapping).

In der vorteilhaften Ausgestaltung nach Patentanspruch 2, wobei die jeweiligen optischen Strukturmerkmale die gleiche Lage (Position und Abstand) relativ zueinander aufweisen, ist sichergestellt, daß der optische Sensor nur in dem Bereich benutzt wird, für den er auch genau vermessen ist.

Besonders genau arbeitet das Verfahren gemäß Patentanspruch 3, wenn die jeweiligen optischen Strukturmerkmale auch eine gleiche bzw. ähnliche Form aufweisen.

Besonders einfach und schnell gestaltet sich das Verfahren gemäß Patentanspruch 4, wenn der Nennabstand kleiner als das Gesichtsfeld des optischen Sensors gewählt wird, so daß die erste und die zweite Korrekturmarke, wie auch die lokalen Referenzmarken und optischen Strukturmerkmale gleichzeitig vom optischen Sensor aufgenommen werden.

Eine weitere Verbesserung der Genauigkeit wird dadurch erzielt, daß gemäß Patentanspruch 5 die lokalen Referenzmarken zumindest näherungsweise an der gleichen Stelle des Gesichtsfelds des optischen Sensors aufgenommen werden wie die erste Korrekturmarke. Dadurch ist sichergestellt, daß für die Vermessung immer der gleiche, bereits kalibrierte Bereich des optischen Sensors verwendet wird.

In der vorteilhaften Vorrichtung zur Durchführung eines Verfahrens nach Patentanspruch 8 verläuft die gedachte Verbindungslinie zwischen den lokalen Referenzmarken und den Strukturmerkmalen senkrecht zu Kanten der Nachbildungen, wodurch die Vermessung nicht durch zusätzliche Reflexionen an weiteren Kanten der Nachbildungen erschwert wird.

Anhand der Figuren der Zeichnung wird die Erfindung in Ausführungsbeispielen näher erläutert. Dabei zeigt
Figur 1 eine Draufsicht auf ein Kalibriersubstrat mit darauf aufgesetzten Nachbildungen von Bauelementen,
Figur 2 einen vergrößerten Ausschnitt aus dem Kalibriersubstrat nach Figur 1 mit der ersten und der zweiten Korrekturmarke.

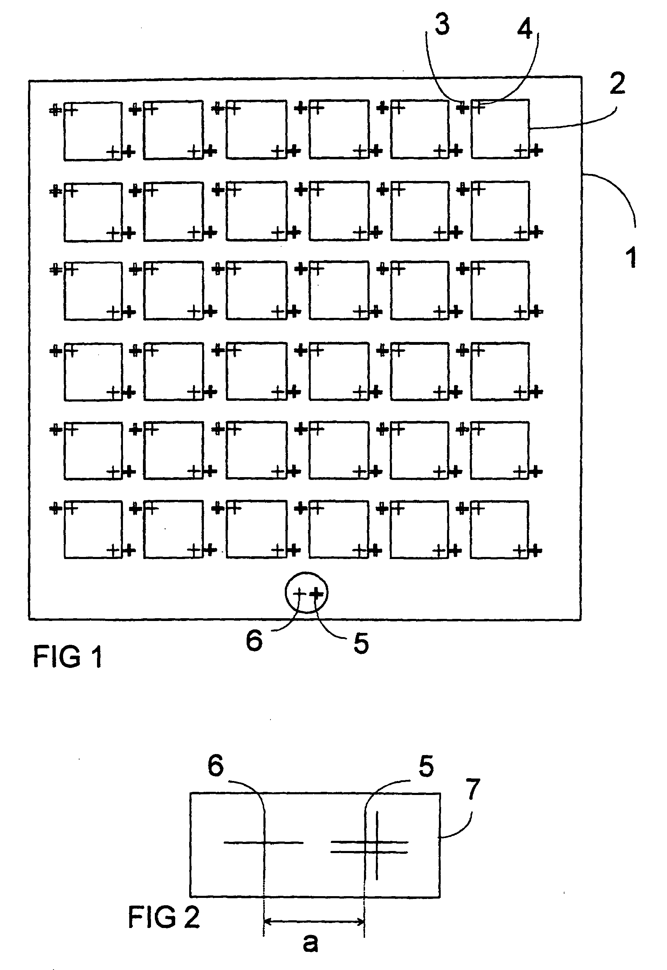

In Figur 1 ist ein Kalibriersubstrat 1 dargestellt, welches in einem Bestückautomaten für elektrische Bauelemente an definierten Stellen mit Nachbildungen 2 solcher Bauelemente bestückt wurde. Dazu wurden die Nachbildungen 2 aus nicht dargestellten Magazinen entnommen und an einer nicht dargestellten Haltevorrichtung bis zum Kalibriersubstrat 1 transportier und an der dafür vorgesehenen Position abgesetzt, analog zum Transport von Bauelementen aus Zuführeinrichtungen bis zur Aufsetzposition auf die Leiterplatte. Die Nachbildungen 2 bestehen aus kleinen Glasplättchen, die jeweils in zwei einander diagonal gegenüberliegenden Ecken Markierungen 4 als optische Strukturmerkmale in der Art von Fadenkreuzen aufweisen. Das Kalibriersubstrat 1 ist an diesen Stellen im engen Abstand zu den Markierungen 4 mit lokalen Referenzmarken 3 versehen, die mit hoher Lagepräzision aufgebracht sind.

Die Markierungen 4 und die Referenzmarken 3 sind so eng benachbart, daß sie in ein Gesichtsfeld 7 eines ortsauflösenden optischen Sensors passen, der an einem Bestückkopf für die Bauelemente befestigt ist. Dieser Bestückkopf ist derart verfahrbar, daß der Sensor über allen markierten Eckbereichen positionierbar ist.

Der ortsauflösende Sensor ist mit einer Auswerteelektronik verbunden, die in der Lage ist, die relative Lage der Markierungen 4 zu der jeweiligen Referenzmarke 3 zu ermitteln, ohne daß dabei der Sensor verfahren werden muß. Ein nicht dargestelltes Steuergerät der Bestückeinrichtung weist ein Auswertemodul auf, das die einzelnen Abweichungen der Markierungen 4 von den Referenzmarken 3 zu Korrekturparametern für die Maschine verarbeitet. Diese Korrekturparameter werden automatisch vom Steuergerät übernommen.

Für eine genaue Kalibrierung des optischen Sensors sind in einem fest vorgegebenen Nennabstand a eine erste Korrekturmarke 5 und eine zweite Korrekturmarke 6 auf dem Kalibriersubstrat 1 angebracht. Der optische Sensor vermißt dabei zunächst den Abstand der ersten 5 und der zweiten 6 Korrekturmarke, und daraus wird im Vergleich mit dem Nennabstand a ein Sensorkorrekturfaktor ermittelt, der bei der Lagebestimmung der Nachbildungen 2 berücksichtigt wird. Vermißt der optische Sensor nun anschließend die Lage der lokalen Referenzmarken 3 relativ zu den Markierungen 4 und wird dabei der gleiche Bereich des Gesichtsfeldes 7 benutzt wie bei der Vermessung der ersten 5 und der zweiten 6 Korrekturmarke, so kann durch die Berücksichtigung des Sensorkorrekturfaktors eine genaue Bestimmung der relativen Lage zwischen Markierung 4 und lokaler Referenzmarke 3 erfolgen. Eine höchstmögliche Genauigkeit wird dadurch erzielt, daß die Stelle im Gesichtsfeld 7, an der die erste Korrekturmarke 5 vermessen wurde, mit der Stelle im Gesichtsfeld 7 übereinstimmt, an der die lokale Referenzmarke 3 vermessen wird. Die Markierung 4 befindet sich dann näherungsweise an der Stelle im Gesichtsfeld 7, an der die zweite Korrekturmarke 6 vorhanden war. Damit wird ein Bereich des Gesichtsfeldes 7 des optischen Sensors verwendet, der vorher bei der Bestimmung des Sensorkorrekturfaktors benutzt wurde, wodurch die gewünschte Genauigkeit im Vermessen des Bestückautomaten erzielt wird.

Die Markierungen 4 sind relativ zu den lokalen Referenzmarken 3 dabei so angeordnet, daß ihre gedachte Verbindungslinie senkrecht zu Kanten der Nachbildungen steht. Dadurch wird der Einfluß von schädlichen Reflexionen auf die Messung der relativen Lage der Markierungen zueinander minimiert.

## Patentansprüche

1. Verfahren zum Kalibrieren eines Verfahrwegs und/oder einer Winkellage einer Haltevorrichtung in einer Einrichtung zur Herstellung von elektrischen Baugruppen, insbesondere zum Bestücken von Leiterplatten mit Bauelementen,
wobei mittels der Einrichtung ein Kalibriersubstrat (1) von der Art einer Leiterplatte an definierten Aufsetzstellen mit scheibenartigen Nachbildungen (2) der Bauelemente bestückt wird,
wobei die Lage der Nachbildungen (2) relativ zu lokalen Referenzmarken (3) des Kalibriersubstrates (1) anhand von lagedefinierten optischen Strukturmerkmalen (z.B.4) der Nachbildungen (2) durch einen ortsauflösenden optischen Sensor ermittelt wird,
**dadurch gekennzeichnet,**
**daß** der optische Sensor den Abstand zwischen einer ersten (5) und einer zweiten (6) Korrekturmarke vermißt, die auf dem Kalibriersubstrat (1) in einem vorgegebenen Nennabstand (a) aufgebracht sind, wobei die lokalen Referenzmarken (3) zumindest näherungsweise an der gleichen Stelle des Gesichtsfelds (7) des optischen Sensors aufgenommen werden wie die erste Korrekturmarke (5) und
**daß** durch Vergleich des gemessenen Abstands mit dem Nennabstand (a) ein Sensorkorrekturfaktor ermittelt wird, der bei der Lagebestimmung der Nachbildungen (2) zur Kompensation einer optischen Verzerrung berücksichtigt wird.

2. Verfahren zum Kalibrieren eines Verfahrwegs und/oder einer Winkellage einer Haltevorrichtung nach Anspruch 1,
**dadurch gekennzeichnet,**
**daß** der Abstand der lokalen Referenzmarken (3) zu den optischen Strukturmerkmalen (z.B.4) näherungsweise gleich dem Nennabstand (a) gewählt wird und
**daß** die Position der optischen Strukturmerkmale (4) relativ zu den lokalen Referenzmarken (3) der relativen Position der zweiten (6) zur ersten (5) Korrekturmarke entspricht.

3. Verfahren zum Kalibrieren eines Verfahrwegs und/oder einer Winkellage einer Haltevorrichtung nach Anspruch 2,
**dadurch gekennzeichnet,**
**daß** die Form der lokalen Referenzmarken (3) und der optischen Strukturmerkmale (4) der Form der ersten (5) und der zweiten (6) Korrekturmarke entspricht.

4. Verfahren zum Kalibrieren eines Verfahrwegs und/oder einer Winkellage einer Haltevorrichtung nach einem der Ansprüche 1, 2 oder 3,
**dadurch gekennzeichnet,**
**daß** der Nennabstand (a) kleiner als das Gesichtsfeld (7) des optischen Sensors gewählt wird, und daß die erste (5) und die zweite (6) Korrekturmarke gleichzeitig vom optischen Sensor aufgenommen werden.

5. Verfahren zum Kalibrieren eines Verfahrwegs und/oder einer Winkellage einer Haltevorrichtung nach einem der Ansprüche 1 bis 4
**dadurch gekennzeichnet,**
**daß** die lokalen Referenzmarken (3) zumindest näherungsweise an der gleichen Stelle des Gesichtsfelds (7) des optischen Sensors aufgenommen werden wie die erste Korrekturmarke (5).

6. Vorrichtung zur Durchführung eines Verfahrens zum Kalibrieren eines Verfahrwegs und/oder einer Winkellage einer Haltevorrichtung, insbesondere nach einem der vorhergehenden Ansprüche,
wobei mittels der Einrichtung ein Kalibriersubstrats (1) von der Art einer Leiterplatte an definierten Aufsetzstellen mit Nachbildungen (2) der Bauelemente bestückt ist,
wobei die Lage der Nachbildungen (2) relativ zu lokalen Referenzmarken (3) des Kalibriersubstrats (1) anhand von lagedefinierten optischen Strukturmerkmalen (z.B.4) der Nachbildungen (2) durch einen optischen Sensor ermittelbar ist und
wobei aus ermittelten Abweichungen der Lage der Strukturmerkmale (z.B.4) von ihrer vorgegebenen Ideallage zumindest ein Korrekturparameter für ein Steuergerät der Einrichtung zur Herstellung der Baugruppen berechenbar ist,
**dadurch gekennzeichnet,**
**daß** eine erste (5) und eine zweite (6) Korrekturmarke so auf dem Kalibriersubstrat (1) angebracht sind, daß ihr vorgegebener Nennabstand (a) zumindest näherungsweise dem Abstand zwischen den lokalen Referenzmarken (3) und den Strukturmerkmalen (z.B.4) entspricht und ihre Position relativ zueinander der relativen Position der lokalen Referenzmarken (3) zu den Strukturmerkmalen (z.B. 4).

7. Vorrichtung nach Anspruch 6,
**dadurch gekennzeichnet,**
**daß** die Korrekturmarken (5,6), die lokalen Referenzmarken (3) und die Strukturmerkmale (z.B.4) als Kreuze ausgebildet sind.

8. Vorrichtung nach einem der Ansprüche 6 oder 7,
**dadurch gekennzeichnet,**
**daß** eine gedachte Verbindungslinie zwischen den lokalen Referenzmarken (3) und den Strukturmerkmalen (4) zumindest näherungsweise senkrecht zu Kanten der Nachbildungen (2) verläuft.

9. Kalibriersubstrat (1) zur Durchführung eines Verfahrens zum Kalibrieren eines Verfahrwegs und/oder einer Winkellage einer Haltevorrichtung, insbesondere nach einem der vorhergehenden Ansprüche,
mit lokalen Referenzmarken (3) in deren Nähe zugeordnete optische Strukturmerkmale (4) von Nachbildungen (2) von elektrischen Bauelementen nach der Bestückung des Kalibriersubstrats (1) mit den Nachbildungen an den dafür vorgesehenen Stellen aufzufinden sind
**gekennzeichnet durch**
eine erste (5) und eine zweite (6) Korrekturmarke, die in einem vorgegebenen Nennabstand (a) voneinander entfernt auf das Kalibriersubstrat (1) aufgebracht sind, wobei der Nennabstand zumindest näherungsweise gleich dem Abstand zwischen den lokalen Referenzmarken (3) und den zugeordneten optischen Strukturmerkmalen (4) ist.

## Claims

1. Method for calibration of a movement path and/or of an angular position of a holding apparatus in a device for producing electrical assemblies, in particular for placing components on printed circuit boards,
with, by means of the device, a calibration substrate (1) such as a printed circuit board being fitted at defined placement points with disc-like models (2) of the components,
with the position of the models (2) relative to the local reference marks (3) on the calibration substrate (1) being determined on the basis of optical structural features (for example 4), whose positions are defined, for the models (2), by means of a position-resolving optical sensor,
**characterized**
**in that** the optical sensor measures the distance between a first (5) and a second (6) correction mark, which are applied to the calibration substrate (1) with a predetermined nominal separation (a) with the local reference marks (3) being recorded at least approximately at the same point in the field of view (7) of the optical sensor as the first correction mark (5), and
**in that** a sensor correction factor is determined by comparison of the measured distance with the nominal separation (a) and being taken into account in the determination of the position of the models (2) in order to compensate for optical distortion.

2. Method for calibration of a movement path and/or of an angular position of a holding apparatus according to Claim 1,
**characterized**
**in that** the distance between the local reference marks (3) and the optical structural features (for example 4) is chosen to be approximately the same as the nominal separation (a), and
**in that** the position of the optical structural features (4) relative to the local reference marks (3) corresponds to the relative position of the second correction mark (6) with respect to the first correction mark (5).

3. Method for calibration of a movement path and/or of an angular position of a holding apparatus according to Claim 2,
**characterized**
**in that** the form of the local reference marks (3) and of the optical structural features (4) corresponds to the form of the first correction mark (5) and of the second correction mark (6).

4. Method for calibration of a movement path and/or of an angular position of a holding apparatus according to one of Claims 1, 2 or 3,
**characterized**
**in that** the nominal separation (a) is chosen to be smaller than the field of view (7) of the optical sensor, and in that the first correction mark (5) and the second correction mark (6) are recorded at the same time by the optical sensor.

5. Method for calibration of a movement path and/or of an angular position of a holding apparatus according to one of Claims 1 to 4,
**characterized**
**in that** the local reference marks (3) are recorded at least approximately at the same point in the field of view (7) of the optical sensor as the first correction mark (5).

6. Apparatus for carrying out a method for calibration of a movement path and/or of an angular position of a holding apparatus, in particular according to one of the preceding claims,
with, by means of the device, a calibration substrate (1) such as a printed circuit board being fitted at defined placement points with models (2) of the components,
with the position of the models (2) relative to the local reference marks (3) on the calibration substrate (1) being determined on the basis of optical structural features (for example 4), whose positions are defined, for the models (2) by means of an optical sensor, and with at least one correction parameter for a controller for the device for producing the assemblies being able to be calculated from the discrepancies determined in the position of the structural features (for example 4) and their predetermined ideal position,
**characterized**
**in that** a first correction mark (5) and a second correction mark (6) are applied to the calibration substrate (1) such that their predetermined nominal separation (a) corresponds at least approximately to the distance between the local reference marks (3) and the structural features (for example 4), and their position relative to one another corresponds to the relative position of the local reference marks (3) with respect to the structural features (for example 4).

7. Apparatus according to Claim 6,
**characterized**
**in that** the correction marks (5, 6), the local reference marks (3) and the structural features (for example 4) are in the form of crosses.

8. Apparatus according to one of Claims 6 or 7,
**characterized**
**in that** an imaginary connecting line between the local reference marks (3) and the structural features (4) runs at least approximately at right angles to the edges of the models (2).

9. Calibration substrate (1) for carrying out a method for calibration of a movement path and/or of an angular position of a holding apparatus, in particular according to one of the preceding claims,
having local reference marks (3) in whose vicinity associated optical structural features (4) of models (2) of electrical components can be found once the models have been fitted at the points intended for this purpose on the calibration substrate (1)
**characterized by**
a first correction mark (5) and a second correction mark (6) which are applied to the calibration substrate (1) at a predetermined nominal separation (a) away from one another, with nominal separation being at least approximately equal to the distance between the local reference marks (3) and the associated optical structural features (4).

## Revendications

1. Procédé pour étalonner un déplacement et/ou une position angulaire d'un système de retenue dans un dispositif destiné à produire des blocs électriques, en particulier destiné à équiper de composants des plaquettes de circuits imprimés,
dans lequel, au moyen dudit dispositif, on équipe de reproductions (2) en forme de disque de composants un substrat d'étalonnage (1) de type plaquette de circuits imprimés à des endroits de pose définis,
dans lequel la position desdites reproductions (2) relativement à des repères de référence locaux (3) du substrat d'étalonnage (1) est détectée, à l'aide de caractéristiques structurelles optiques (p.ex. 4) de position définie des reproductions (2), par un palpeur optique à pouvoir de résolution locale,
**caractérisé en ce que**
le palpeur optique mesure la distance entre un premier (5) et un deuxième repère de correction (6) placés sur le substrat d'étalonnage (1) à une distance nominale (a) prédéfinie, les repères de référence locaux (3) étant enregistrés au moins approximativement au même endroit du champ de vision (7) du palpeur optique que le premier repère de correction (5), et
**en ce qu'**en comparant la distance mesurée avec la distance nominale (a), on détermine un facteur de correction pour le palpeur, que l'on prend en compte lors de la détermination de la position des reproductions (2) pour compenser une distorsion optique.

2. Procédé pour étalonner un déplacement et/ou une position angulaire d'un système de retenue selon la revendication 1,
**caractérisé en ce que**
on choisit la distance des repères de référence locaux (3) par rapport aux caractéristiques structurelles optiques (p.ex. 4) approximativement égale à la distance nominale (a) et
**en ce que** la position des caractéristiques structurelles optiques (4) relativement aux repères de référence locaux (3) correspond à la position relative du deuxième (6) par rapport au premier repère de correction (5).

3. Procédé pour étalonner un déplacement et/ou une position angulaire d'un système de retenue selon la revendication 2,
**caractérisé en ce que**
la forme des repères de référence locaux (3) et des caractéristiques structurelles optiques (4) correspond à la forme du premier (5) et du deuxième repère de correction (6).

4. Procédé pour étalonner un déplacement et/ou une position angulaire d'un système de retenue selon la revendication 1, 2 ou 3,
**caractérisé en ce que**
on choisit la distance nominale (a) inférieure au champ de vision (7) du palpeur optique et **en ce que** le premier (5) et le deuxième repère de correction (6) sont enregistrés simultanément par le palpeur optique.

5. Procédé pour étalonner un déplacement et/ou une position angulaire d'un système de retenue selon l'une des revendications 1 à 4,
**caractérisé en ce que**
les repères de référence locaux (3) sont enregistrés au moins approximativement au même endroit du champ de vision (7) du palpeur optique que le premier repère de correction (5).

6. Dispositif destiné à la mise en oeuvre du procédé pour étalonner un déplacement et/ou une position angulaire d'un système de retenue, en particulier selon l'une des revendications précédentes,
dans lequel, au moyen du dispositif, un substrat d'étalonnage (1) de type plaquette de circuits imprimés est équipé de reproductions (2) des composants à des endroits de pose définis,
dans lequel la position desdites reproductions (2) relativement à des repères de référence locaux (3) du substrat d'étalonnage (1) peut être détectée, à l'aide de caractéristiques structurelles optiques (p.ex. 4) de position définie des reproductions (2), par un palpeur optique et
dans lequel, à partir d'écarts détectés de la position des caractéristiques structurelles (p.ex. 4) par rapport à leur position idéale prédéfinie, au moins un paramètre de correction pour un appareil de commande du dispositif destiné à produire des blocs peut être calculé,
**caractérisé en ce que**
un premier (5) et un deuxième repère de correction (6) sont placés de telle manière sur le substrat d'étalonnage (1) que leur distance nominale (a) prédéfinie correspond au moins approximativement à la distance entre les repères de référence locaux (3) et les caractéristiques structurelles (p.ex. 4) et que leur position l'un par rapport à l'autre correspond à la position relative des repères de référence locaux (3) par rapport aux caractéristiques structurelles (p.ex. 4).

7. Dispositif selon la revendication 6,
**caractérisé en ce que**
les repères de correction (5, 6), les repères de référence locaux (3) et les caractéristiques structurelles (p.ex. 4) sont réalisés sous forme de croix.

8. Dispositif selon l'une des revendications 6 ou 7,
**caractérisé en ce qu'**une ligne de liaison imaginaire entre les repères de référence locaux (3) et les caractéristiques structurelles (4) s'étend au moins approximativement perpendiculairement à des bords des reproductions (2).

9. Substrat d'étalonnage (1) destiné à la mise en oeuvre d'un procédé pour étalonner un déplacement et/ou une position angulaire d'un système de retenue, en particulier selon l'une des revendications précédentes,
doté de repères de référence locaux (3) à proximité desquels on peut trouver des caractéristiques structurelles optiques (4) associées de reproductions (2) de composants électriques après avoir équipé le substrat d'étalonnage (1) desdites reproductions aux endroits prévus à cet effet,
**caractérisé par**
un premier (5) et un deuxième repère de correction (6) placés éloignés l'un de l'autre à une distance nominale (a) prédéfinie sur le substrat d'étalonnage (1), ladite distance nominale étant au moins approximativement égale à la distance entre les repères de référence locaux (3) et les caractéristiques structurelles optiques (4) associées.
